(19) Europäisches Patentamt
European Patent Office
Office européen des brevets

(11) **EP 2 378 667 A2**

(12) **EUROPEAN PATENT APPLICATION**

(43) Date of publication:
**19.10.2011 Bulletin 2011/42**

(51) Int Cl.:
***H03M 1/10*** (2006.01)     *H03M 1/66* (2006.01)

(21) Application number: **11250476.6**

(22) Date of filing: **15.04.2011**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **15.04.2010 JP 2010094413**

(71) Applicant: **TEKTRONIX, INC.**
**Beaverton, OR 97077-0001 (US)**

(72) Inventor: **Sakai, Ryoichi**
**Mishima-shi**
**Shizuoka-ken, 411-0023 (JP)**

(74) Representative: **Brinck, David John Borchardt et al**
**R.G.C. Jenkins & Co**
**26 Caxton Street**
**London SW1H 0RJ (GB)**

(54) **Method for compensating a frequency characteristic of an arbitrary waveform generator**

(57) An arbitrary waveform generator converts digital waveform data stored in a memory into an analog output signal by using a digital-to-analog converter. In order to make the frequency characteristics of the output signal flat, the created digital waveform data is modified in accordance with a predetermined S-parameter of the arbitrary waveform generator, and the modified digital waveform data is stored in the memory for generating the analog signal having the compensated frequency characteristics.

FIG. 11

## Description

## Field of the Invention

The present invention relates to a method for compensating frequency characteristics of an arbitrary waveform generator that generates an analog signal by converting digital waveform data stored in a memory into the analog signal using a digital-to-analog converter.

## Background of the Invention

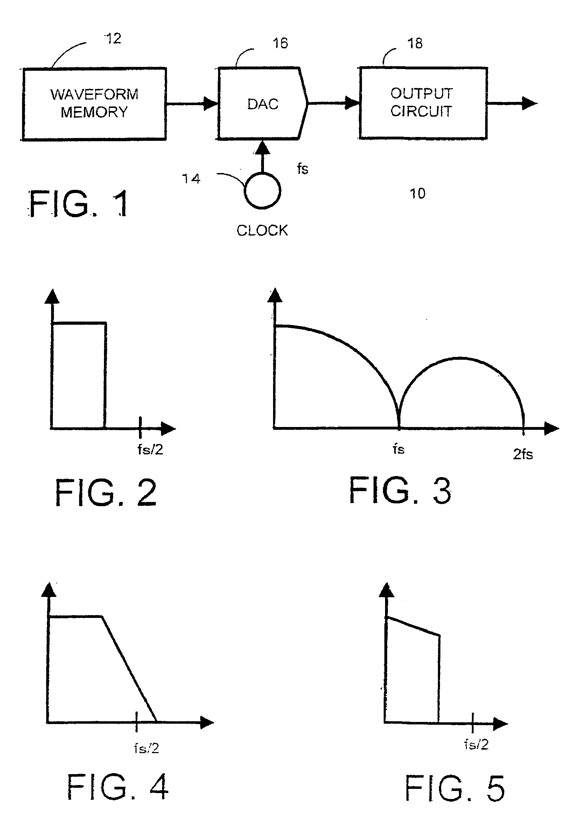

When testing various kinds of analog electronics circuits, a reference analog signal appropriate for such a test is applied to an analog circuit under test. An arbitrary waveform generator is an optimum measurement instrument for generating the reference analog signal. FIGURE 1 shows a simplified block diagram of a conventional arbitrary waveform generator 10. A user creates digital waveform data representative of a desired arbitrary waveform by using the arbitrary waveform generator, a personal computer, a workstation or the like under control of waveform creation software. The created digital waveform data is time-domain data representing amplitude values vs. time. The waveform data is stored in a waveform digital memory 12. In the waveform memory 12, amplitude values of the waveform data are stored at address locations in the memory 12 with the address locations corresponding to time. The digital waveform data is read out from the waveform memory 12 in synchronism with a clock signal generated by a clock generator 14 having a frequency, fs. The digital waveform data is converted into an analog signal by a digital-to-analog converter (DAC) 16 in synchronism with the clock signal. The frequency fs corresponds to a sampling frequency of the analog signal. The converted analog signal is processed by a reconfiguration filter (in general a lowpass filter), an amplifier, an attenuator and the like in an output circuit 18 in order to generate the analog output signal having desired bandwidth and amplitude. In the description below, the analog output circuitry within the digital-to-analog converter 16 is considered as part of the output circuit 18. Although FIGURE 1 does not show an interface circuit for receiving the digital waveform data and a control circuit for controlling a writing/reading operation of the waveform memory 12, these circuits can be accomplished by a conventional interface and a conventional control circuit such as a microprocessor system and the like.

Recent advances in semiconductor technology has allowed the development of ultra-high speed arbitrary waveform generators having sampling speeds over 10GS/s, which can directly generate a wideband microwave signal without up-conversion. The frequency characteristics of the arbitrary waveform generator depends on mathematical "sinc" frequency characteristics of the digital-to-analog converter and frequency characteristics of a signal path from the analog output circuitry within the digital-to-analog converter 16 to the output terminal of the arbitrary waveform generator. The non-linearity of these frequency characteristics causes a non-flat frequency response of the arbitrary waveform generator. Therefore, some frequency compensation is required in order to generate a wideband signal having desired frequency characteristics.

A general digital-to-analog converter generates a staircase waveform as an analog output signal. This output type is called a zero-order hold and its frequency characteristics can be represented by using sinc or sin (x)/x. The sinc characteristics have amplitude and phase characteristics as follows:

$$\mathrm{sinc(f)}=[(\sin(\pi f/fs))/(\pi f/fs)]e^{-j\pi f/fs}$$

wherein "f" represents an output frequency and "fs" represents the sampling frequency of the analog signal. In the sinc characteristics, the value at DC is one and the value at an integral multiple frequency of fs is zero. The sinc characteristics are common to all arbitrary waveform generators which depend only on the sampling frequency and can be determined by using a mathematical calculation. On the other hand, the frequency characteristics of the arbitrary waveform generator in an actual circuit are the frequency characteristics of the signal path from the analog output circuitry within the digital-to-analog converter 16 to the output terminal of the arbitrary waveform generator, namely, the frequency characteristics of the output circuit 18. The frequency characteristics of the output circuit 18 are not affected by the sinc characteristics sampling frequency. However, the frequency characteristics of the output circuit 18 vary in every arbitrary waveform generator because the frequency characteristics are determined by the design and layout of the circuit.

The frequency characteristics of an arbitrary waveform generator will be further described by reference to graphs of frequency characteristics shown in FIGURES 2 through 5 and FIGURES 7 and 9. An assumption is made that the frequency characteristics of the digital waveform data from the waveform memory 12 are flat as shown in FIGURE 2 and the digital-to-analog converter 16 is an ideal converter having an infinite bandwidth. In this case, the frequency characteristics of the digital-to-analog converter 16 are the sinc function as shown in FIGURE 3. Further, it is assumed that the output circuit 18 has frequency characteristics shown in FIGURE 4 wherein the output circuit 18 comprises the analog output circuitry within the digital-to-analog converter 16, filter, amplifier, attenuator, connector, etc. The frequency response of the output analog signal from the arbitrary waveform generator is a function of the overall frequency characteristics of the arbitrary waveform generator. The overall frequency characteristics are determined by multiplying the frequency characteristics of the input waveform data (FIGURE 2), the digital-to-analog converter 16 (the sinc characteristics shown in FIGURE 3) and the output circuit 18 (the frequency characteristics of FIGURE 4). Therefore, the overall frequency characteristics are not flat as illustrated in FIGURE 5. In FIGURES 2 through 5 as well as FIGURES 7 and 9 that will be described hereinafter, horizontal axes represent the time and vertical axes represent the analog or digital amplitude. It should be noted that FIGURE 2 explains the characteristics of both the digital input data and the analog output data.

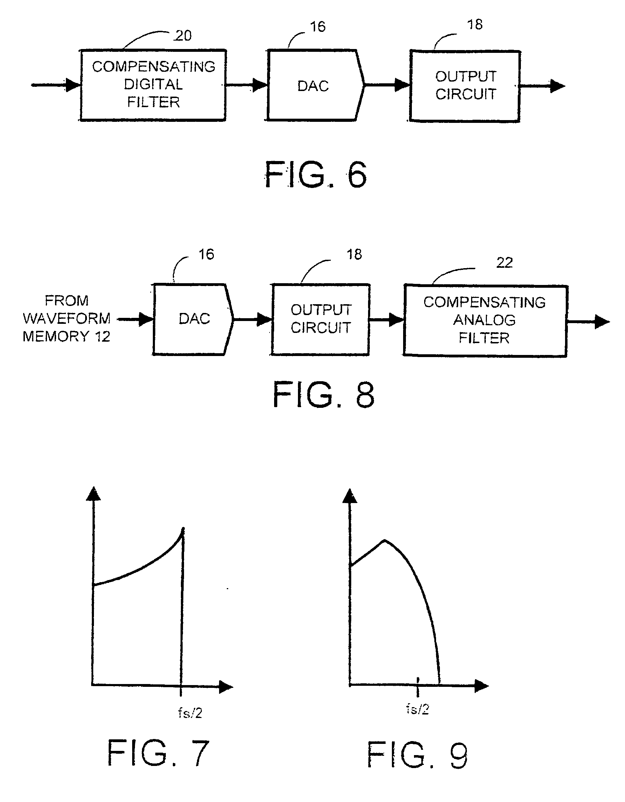

FIGURE 6 shows a conventional technology for frequency compensation that makes the overall frequency characteristics of the arbitrary waveform generator flat. In this example, a compensating digital filter 20 is inserted between the waveform memory 12 (not shown) and the digital-to-analog converter (DAC) 16. The digital filter 20 has frequency characteristics that compensate the sinc characteristics of the digital-to-analog converter 16 as shown in FIGURE 7. Even if the sampling frequency, fs, is variable, it is not necessary to modify the configuration of the digital filter 20. The digital filter 20 can also provide compensation for the frequency characteristics of the output circuit 18. The overall frequency characteristics of the arbitrary waveform generator are then determined by multiplying the frequency characteristics of the input waveform data (FIGURE 2), the digital filter 20 (FIGURE 7), the digital-to-analog converter 16 (the sinc characteristics of FIGURE 3) and the output circuit 18 (the frequency characteristics shown in FIGURE 4). The resulting overall frequency characteristics are flat as illustrated in FIGURE 2.

FIGURE 8 shows another conventional technology for frequency compensation in order to make the overall frequency characteristics of the arbitrary waveform generator flat. In this example, a compensating analog filter 22 is positioned subsequent to the output circuit 18. The analog filter 22 has frequency characteristics shown in FIGURE 9 for compensating the frequency characteristics of the digital-to-analog converter 16, and, if necessary, for compensating the frequency characteristics of the output circuit 18. Therefore, the frequency characteristics of the arbitrary waveform generator are determined by multiplying the frequency characteristics of the input waveform data (FIGURE 2), the digital-to-analog converter 16 (the sinc characteristics of FIGURE 3), the output circuit 18 (the frequency characteristics of FIGURE 4) and the analog filter 22 (FIGURE 9). The resulting overall frequency characteristics are flat as depicted in FIGURE 2. Since the compensating analog filter 22 is provided subsequent to the digital-to-analog converter 16, the sampling frequency, fs, should be fixed instead of a variable frequency.

Unexamined Japanese Patent Publication No. H03-88504 published April 12, 1991 and entitled "Arbitrary Waveform Generator" discloses prior art that compensates amplitude linearity of the arbitrary waveform generator instead of the frequency characteristics. According to this conventional technology, the amplitude characteristics of a digital-to-analog converter are measured to obtain an error correction data and produce an error compensation table that is stored in a memory. The created digital waveform data is compensated by reference to the error compensation table and the compensated waveform data is stored in a waveform memory. The linearity compensated analog output signal is generated by converting the compensated waveform data from the waveform memory into an analog signal by the digital-to-analog converter.

The frequency compensation technologies using the compensating digital filter explained by reference to FIGURE 6 and the compensating analog filter explained by reference to FIGURE 8 are useful for a relatively low sampling frequency, fs. However, it is difficult to configure the frequency compensating digital and analog filters for an arbitrary waveform generator having a very high sampling frequency in the tens of gigahertz. In addition, the prior art disclosed in the above Unexamined Japanese Patent Publication No. H03-88504 is to compensate the amplitude linearity instead of the frequency characteristics.

Another conventional frequency compensation approach is proposed wherein compensated digital waveform data stored in a waveform memory is produced from initial digital waveform data that is corrected prior to storing in a waveform memory, which is similar to the above Unexamined Japanese Patent Publication from the viewpoint of the previous correction. In this approach, an ultra-high speed arbitrary waveform generator proceeds with the following steps in order to make its frequency characteristics flat. First, the digital waveform data is created having flat frequency characteristics and the arbitrary waveform generator generates an analog output signal in accordance with the flat waveform data. Then, the analog output signal is measured by a wideband oscilloscope or spectrum analyzer to obtain attenuation characteristics. The digital waveform data is recreated by reference to the attenuation characteristics. In this frequency compensation method, a user must measure the frequency characteristics of the arbitrary waveform generator as a function of the measured output signal and correct the waveform data by reference to the measurement results. Therefore, an additional measurement instrument is required for the compensation process that results in increased expense and time for the process. Moreover, it is very troublesome to consider frequency characteristics of a user's equipment when compensating the analog output signal from the arbitrary waveform generator in a case where the analog output signal is applied to a device under test through the user's equipment.

What is desired is a method for easily and simply compensating frequency characteristics of a signal generator that generates an arbitrary waveform having a very high sampling frequency fs in consideration of frequency characteristics of a user's equipment.

## Summary of the Invention

Accordingly, the present invention provides a method for compensating frequency characteristics of an arbitrary waveform generator that produces an analog signal by converting digital waveform data stored in a memory into the analog signal with a digital-to-analog converter. First, the digital waveform data is created with waveform creation software. The created digital waveform data is modified in accordance with predetermined S-parameters for the arbitrary waveform generator, and the modified digital waveform data is stored in a memory. The arbitrary waveform generator can generate a frequency compensated analog output signal by converting the modified waveform data stored in the memory into the analog output signal.

According to the present invention, a nonvolatile storage means stores the S-parameters representative of the frequency characteristics of the arbitrary waveform generator. Therefore, the waveform data can be modified by the stored S-parameters with an easy calculation every time the digital waveform data is created. Since S-parameters are used, the frequency compensation is not affected by the sampling frequency fs. By using S-parameters of a user's equipment connected to the output terminal of the arbitrary waveform generator, it is easy to add the frequency characteristics of the user's equipment to the frequency characteristics of the arbitrary waveform generator.

There are some approaches for modifying the created digital waveform data in accordance with the S-parameters. The original S-parameters show that amplitude decreases with frequency. In an example of the approaches, the original S-parameters are processed for frequency compensation. For this, the inverse of the characteristics of the S-parameters, as well as the sinc characteristics, are derived so that the overall frequency characteristics of the arbitrary waveform generator are flat. In the inverse characteristics, the amplitude increases with frequency. An inverse Fourier transform is performed on the processed S-parameters to produce compensation coefficients in a time domain. The compensation coefficients in the time domain are convolved with the digital waveform data to produce the modified digital waveform data in the time domain. Another approach of this modifying step is as follows. First, the S-parameters are processed for the frequency compensation to produce the compensation coefficients in the frequency domain. Then, a Fourier transform is performed on the digital waveform data. The Fourier transformed digital waveform data is modified in accordance with the compensation coefficients of the frequency domain. The inverse Fourier transform is performed on the modified digital waveform data to form the modified digital waveform data in the time domain.

The objects, advantages and other novel features of the present invention are apparent from the following detailed description when read in conjunction with the appended claims and drawing.

## Brief Description of the Drawing

FIGURE 1 is a block diagram of a conventional arbitrary waveform generator.

FIGURE 2 is a graph illustrating frequency characteristics of input digital data or output analog data.

FIGURE 3 is a graph of the frequency characteristics of a digital-to-analog converter.

FIGURE 4 is a graph of the frequency characteristics of an output circuit.

FIGURE 5 is a graph of the frequency characteristics of output analog data.

FIGURE 6 is a block diagram of a part of an arbitrary waveform generator for explaining one conventional frequency compensation methods.

FIGURE 7 is a graph of the frequency characteristics of a compensating digital filter used in FIGURE 6.

FIGURE 8 is a block diagram of a part of an arbitrary waveform generator for explaining another conventional frequency compensation method.

FIGURE 9 is a graph of the frequency characteristics of a compensating analog filter used in FIGURE 8.

FIGURE 10 is a signal flow diagram for explaining S-parameters used for the present invention.

FIGURE 11 is a block diagram of an arbitrary waveform generator and a personal computer or a work station used for the present invention.

FIGURE 12 is flow chart for explaining a method of compensating frequency characteristics for the arbitrary waveform generator according to the present invention.

FIGURE 13 is flow chart for explaining one example for modifying waveform data with S-parameters in a method of compensating frequency characteristics for the arbitrary waveform generator according to the present invention.

FIGURE 14 is flow chart for explaining another example for modifying waveform data with the S-parameters in a method of compensating frequency characteristics for the arbitrary waveform generator according to the present invention.

## Detailed Description of the Preferred Embodiments

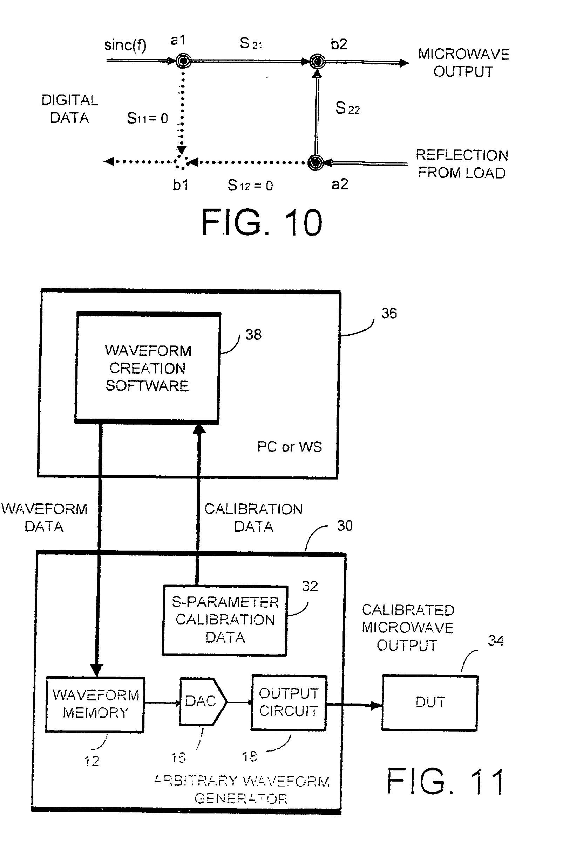

S-parameters used for the present invention will be discussed by reference to FIGURE 10 of a signal flow diagram. S-parameters are most suitable for modeling frequency characteristics of an ultra-high speed arbitrary waveform generator having a sampling frequency of tens of gigahertz and a bandwidth over 10GHz because S-parameters considers reflection. As described hereinbefore, the frequency characteristics of the arbitrary waveform generator comprise frequency characteristics of a digital-to-analog converter and that of an output circuit. The frequency characteristics of the digital-to-analog converter can be determined mathematically and are sinc characteristics that depend only on the sampling frequency. The frequency characteristics of the output circuit are based on the design, layout and components. The S-parameters of the arbitrary waveform generator can be represented by two-port S-parameter model, as is illustrated by the signal flow shown in FIGURE 10 where port 1 is on the left and port 2 is on the right. General expressions of the S-parameters are as follows:

$$b1 = S11*a1 + S12*a2$$

$$b2 = S21*a1 + S22*a2$$

wherein "*" represents a multiplication sign.

Since the subject for the present invention is the arbitrary waveform generator, the input data at port 1 is digital data having sinc(f) characteristics. The output at port 2 is an analog waveform (microwave output). When an impedance load at the port 2 is shifted from the characteristic impedance load of the arbitrary waveform generator, a reflection wave is produced at the port 2. However, when the impedance load at the port 2 is substantially equal to the characteristic impedance, no reflection wave is produced. A difference from a general two-port S-parameter model is that no reflection occurs at the port 1 because the input data is the digital data. Therefore, in the S-parameter model, S11 and S12 are equal to zero. The S-parameter S21 represents the transmission characteristic of the digital-to-analog converter and the output circuit. The S-parameter 21 has amplitude components and phase components, namely, real parts and imaginary parts. The S-parameter S22 represents reflection characteristics of the arbitrary waveform generator. It should be noted that the S-parameters have individual values for each frequency.

In the present invention, these S-parameters S21 and S22 are measured during the manufacturing of the arbitrary waveform generator and the S-parameters are stored in nonvolatile storage means, such as a hard disk drive, ROM, EEPROM, flash memory or the like. A TouchStone file format may be used to store the S-parameters.

Since the input data is digital data and the output data is analog data in the arbitrary waveform generator, a general-purpose network analyzer cannot be used to measure the parameter S21. In order to measure the S-parameter S21, the arbitrary waveform generator is set to generate a step signal. The generated step signal is acquired and measured by a sampling oscilloscope using S-parameter measurement software, such as 80SSPAR IConnect S-Parameter and Z-Line Software, manufactured and sold by Tektronix, Inc. Beaverton, Oregon. Another approach is to set the arbitrary waveform generator to generate a sine wave signal. The sine wave signal is acquired and measured by the sampling oscilloscope using the S-parameter measurement software. The parameter S22 can be measured by a sampling oscilloscope using TDR software, such as 80SICON IConnect Signal Integrity TDR and S-Parameter Software, manufactured and sold by Tektronix, Inc. Beaverton, Oregon, or the network analyzer. If there is no reflection from the load, the parameter S22 can be ignored. If there are reflections from the load, the parameter S21 and the parameter S22 can be combined to a new parameter S21 by using transformation.

FIGURE 11 is a block diagram of the arbitrary waveform generator and a personal computer (PC) or a workstation (WS) used for the present invention. The arbitrary waveform generator 30 comprises the waveform memory 12 for storing the digital waveform data, the digital-to-analog converter (DAC) 16 for converting the waveform data from the waveform memory 12 to the analog signal, and the output circuit 18 that includes the analog output circuitry within the digital-to-analog converter 16, a reconfiguration filter, an amplifier, an attenuator and the like similarly to the prior art shown in FIGURE 1. The arbitrary waveform generator 30 further comprises a nonvolatile storage means 32, such as a hard disk drive, ROM, EEPROM, flash memory, etc. for storing the S-parameter S21 characteristics as calibration data. The arbitrary waveform generator 30 further includes a control means, such as a microprocessor and the like, a clock generator, an interface for transmitting/receiving the digital data, etc. although they are not shown in FIGURE 11 to simplify the drawing. The analog output signal from the output circuit 18 is applied to a device under test (DUT) 34. The nonvolatile storage means 32 stores the S-parameter S21 for the arbitrary waveform generator wherein this parameter is derived by measuring it or combining the S-parameters S-21 and S-22 parameters to one S-parameter S-21 as discussed hereinbefore.

The personal computer (PC) or the work station (WS) 36 (hereinafter referred simply to as PC) comprises a microprocessor, a hard disk drive, a memory, an interface, an input device and a display device, and operates on an operating system, such as Microsoft ® Windows ®. The waveform creation software 38 for the arbitrary waveform generator 30 runs on the PC 36. The function of the PC 36 may be implemented in the arbitrary waveform generator 30 and may act as the control means for the arbitrary waveform generator 30.

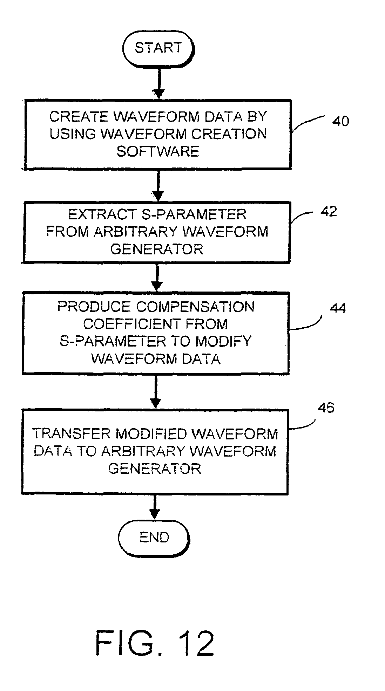

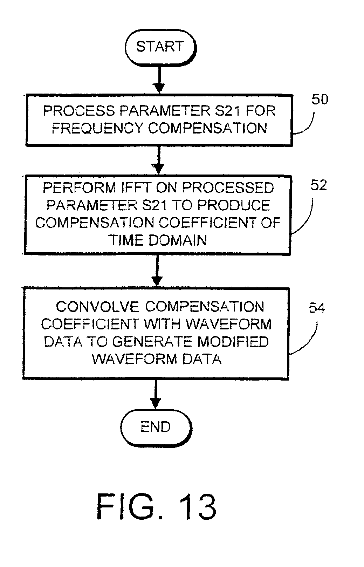

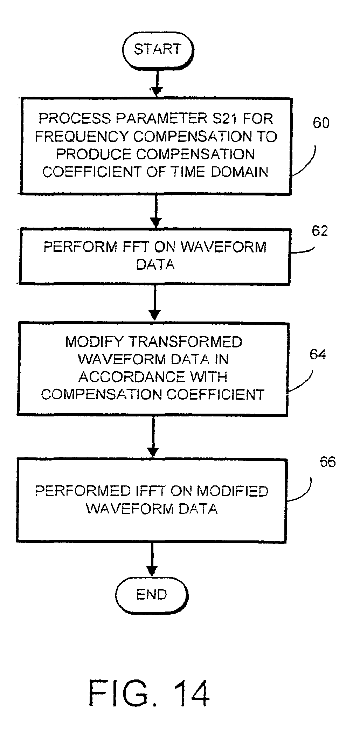

The method for compensating the frequency characteristics of the arbitrary waveform generator according to the present invention will be discussed hereinafter by reference to a flow chart of FIGURE 12. In step 40, the PC 36 creates digital waveform data in accordance with waveform creation software, the waveform data representing a waveform generated by the arbitrary waveform generator 30. In response to user's instruction or completion of the waveform data creation, the PC 36 automatically extracts the S-parameter (e.g. parameter S21) from the nonvolatile storage means 32 within the arbitrary waveform generator 30 and stores it in the memory within the PC 36 at step 42. In a step 44, frequency compensation coefficients are produced from the S-parameter S21 extracted by the PC 36 in order to modify the waveform data. Step 44 will be further discussed in detail hereinafter by reference to FIGURES 13 and 14. In step 46, the frequency compensated waveform data is transferred from the PC 36 to the waveform memory 12 in the arbitrary waveform generator 30. Therefore, the arbitrary waveform generator 30 can generate the frequency compensated arbitrary waveform. It should be noted that the steps 42, 44 and 46 are executed by the microprocessor in accordance with the frequency compensation software stored in the PC 36. Alternately, the waveform creation software and the frequency compensation software may be stored in the memory 12 of the arbitrary waveform generator 12. The frequency compensation coefficients produced from the S-parameter S21 are generated in the arbitrary waveform generator 30. As a result, the S-parameter (e.g. parameter S21) from the nonvolatile storage means 32 within the arbitrary waveform generator 30 is not extracted by the PC36 as recited in step 42 nor is the frequency compensated waveform data transferred from the PC 36 to the waveform memory 12 in the arbitrary waveform generator 30 as recited in step 46.

FIGURE 13 shows a flow chart for explaining one example of the step 44 in the flow chart shown in FIGURE 12. In step 50, the S-parameter S21 is read out from the nonvolatile storage means 32 of the arbitrary waveform generator 30 and is processed for the frequency compensation. The original S-parameter S21 shows a characteristic that the amplitude decreases with frequency. The original S-parameter S21 is modified to indicate a reverse characteristic with respect to the original S-parameter S21 such that the modified S-parameter S21 shows that the amplitude increases with frequency in order to make the frequency characteristics of the arbitrary waveform generator flat by taking the sinc characteristics into account. It should be noted that the S-parameter is in the frequency domain but the digital waveform data is in the time domain. In step 52, an inverse Fourier transform, such as IFFT (Inverse Fast Fourier Transform), is performed on the processed S-parameter S21 to produce the compensation coefficients in the time domain. The time domain compensation coefficients represent the impulse response of the reverse characteristics of the S-parameter S-21 where each magnitude value is associated with a time value. In step 54, the compensation coefficients in the time domain are convolved with the digital waveform data in the time domain to generate the modified or frequency compensated digital waveform data. The compensated digital waveform data is transferred to the waveform memory 12 of the arbitrary waveform generator 30 by step 46 shown in FIGURE 12. In the method of FIGURE 13, the frequency characteristics are compensated in the time domain.

FIGURE 14 illustrates a flow chart of another example of the step 44 in FIGURE 12. In step 60, the parameter S21 is processed for the frequency compensation by taking the sinc characteristics into consideration similarly to the step 50 in FIGURE 13. The results thereof are compensation coefficients in the frequency domain. In step 62, a Fourier transfer, such as FFT (Fast Fourier Transfer), is performed on the created digital waveform data in order to convert the digital waveform data in the time domain into the digital waveform data in the frequency domain. The order of steps 60 and 62 can be reversed or these steps can be executed simultaneously. In step 64, the frequency domain digital waveform data is multiplied with the compensation coefficients derived at the step 60 in order to generate frequency compensated digital waveform data. In step 66, an inverse Fourier transfer, such as IFFT (Inverse Fast Fourier Transfer), is performed on the frequency compensated digital waveform data in the frequency domain so as to convert it into the compensated time domain digital waveform data. The compensated time domain waveform data is transferred into the waveform memory 12 in the arbitrary waveform generator 30 by step 46 in FIGURE 12. As explained hereinbefore, the method illustrated in FIGURE 14 compensates the frequency characteristics in the frequency domain and converts the results into the time domain. It should be noted that the number of steps for the frequency compensation in the time domain is less than that of steps for the frequency compensation in the frequency domain.

The processes of FIGUREs 13 and 14 compensate the frequency characteristics of the arbitrary waveform generator 30. There are test procedures where the analog output signal from the arbitrary waveform generator is applied to another piece of test equipment prior to being applied to a device under test (DUT). It may be necessary to compensate for the frequency characteristics of the other piece of test equipment to maintain a flat analog output signal to the DUT. For this purpose, the frequency characteristics of the test equipment can be considered when creating the compensation coefficients from the S-parameter S21 at step 44 in FIGURE 12. In this case, the S-parameter S21 of the test equipment is measured similarly to the S-parameter S21 measurements of the arbitrary waveform generator and the measured S-parameter S21 is combined with the S-parameter S21 of the arbitrary waveform generator to produce a single S-parameter S21. This operation can be made by multiplying the S-parameter S21 of the arbitrary waveform generator with the S-parameter S21 of the test equipment to produce a combined S-parameter S21 of the arbitrary waveform generator and the test equipment. The resulting S-parameter S21 can be used at step 50 in FIGURE 13 and step 60 in FIGURE 14 to compensate for the frequency characteristics of both the arbitrary waveform generator and the test equipment. Therefore, the frequency characteristics of the arbitrary waveform signal at the input terminal of the device under test can be flat.

Although the preferred embodiment, which incorporate the teachings of the present invention, has been shown and described in detail herein, those skilled in the art will readily understand that many other varied embodiments would still incorporate these teachings.

## Claims

1. A method for compensating frequency characteristics of an arbitrary waveform generator that generates an analog signal by converting digital waveform data stored in a memory into the analogy signal with a digital-to-analog converter, comprising the steps of:

   creating the digital waveform data in accordance with waveform creation software;
   modifying the created digital waveform data in accordance with a predetermined S-parameter for the arbitrary waveform generator; and
   storing the modified digital waveform data in the memory for generating the analog signal.

2. The method as in claim 1 wherein the modifying step comprises the steps of:

   processing the S-parameter for frequency compensation;
   performing an inverse Fourier transform on the processed S-parameter to produce compensation coefficients in the time domain; and
   convoluting the time domain compensation coefficients with the created digital waveform data to produce compensated digital waveform data.

3. The method as in claim 1 wherein the modifying step comprises the steps of:

   processing the S-parameter to produce frequency compensation coefficients in the frequency domain;
   performing a Fourier transform on the digital waveform data to generate frequency domain digital waveform data;
   compensating the frequency domain digital waveform data using the frequency compensation coefficients to generate frequency compensated digital waveform data in the frequency domain; and
   performing an inverse Fourier transform on the frequency compensated digital waveform data in the frequency domain to generate frequency compensated digital waveform data in the time domain:

FIG. 1

FIG. 2

FIG. 3

FIG. 4

FIG. 5

FIG. 6

FIG. 8

FIG. 7

FIG. 9

sinc(f)  a1   $S_{21}$   b2   MICROWAVE OUTPUT

DIGITAL DATA

$S_{11} = 0$

$S_{22}$

b1   $S_{12} = 0$   a2   REFLECTION FROM LOAD

# FIG. 10

WAVEFORM CREATION SOFTWARE  38   36

PC or WS

WAVEFORM DATA

CALIBRATION DATA   30

S-PARAMETER CALIBRATION DATA   32

CALIBRATED MICROWAVE OUTPUT

34

WAVEFORM MEMORY   DAC   OUTPUT CIRCUIT   DUT

12   16   18

ARBITRARY WAVEFORM GENERATOR

# FIG. 11

START

CREATE WAVEFORM DATA BY USING WAVEFORM CREATION SOFTWARE ⟋ 40

EXTRACT S-PARAMETER FROM ARBITRARY WAVEFORM GENERATOR ⟋ 42

PRODUCE COMPENSATION COEFFICIENT FROM S-PARAMETER TO MODIFY WAVEFORM DATA ⟋ 44

TRANSFER MODIFIED WAVEFORM DATA TO ARBITRARY WAVEFORM GENERATOR ⟋ 46

END

FIG. 12

START

PROCESS PARAMETER S21 FOR FREQUENCY COMPENSATION — 50

PERFORM IFFT ON PROCESSED PARAMETER S21 TO PRODUCE COMPENSATION COEFFICIENT OF TIME DOMAIN — 52

CONVOLVE COMPENSATION COEFFICIENT WITH WAVEFORM DATA TO GENERATE MODIFIED WAVEFORM DATA — 54

END

FIG. 13

START

PROCESS PARAMETER S21 FOR
FREQUENCY COMPENSATION TO
PRODUCE COMPENSATION
COEFFICIENT OF TIME DOMAIN          60

PERFORM FFT ON WAVEFORM
DATA          62

MODIFY TRANSFORMED
WAVEFORM DATA IN
ACCORDANCE WITH
COMPENSATION COEFFICIENT          64

PERFORMED IFFT ON MODIFIED
WAVEFORM DATA          66

END

# FIG. 14

**EP 2 378 667 A2**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H0388504 B